# EUROPEAN PATENT SPECIFICATION

(11) **EP 1 372 160 B1**
(45) Date of publication and mention of the grant of the patent: **28.05.2008**
(21) Application number: 03447146.6
(22) Date of filing: 10.06.2003
(51) Int. Cl.: H01B 3/10, H01L 29/04, C01G 27/02, C23C 16/40

(54) **Transistors or memory capacitors comprising a composition of HfO2 with enhanced dielectric constant**
Transistoren und Speicherkondensatoren enthaltend eine HfO2-Zusammensetzung mit erhöhter Dielektrizitätskonstante
Transistors et condensateurs mémoires comprenant une composition de HfO2 avec constante diélectrique augmentée

(30) Priority: 10.06.2002 US 387487 P
(43) Date of publication of application: 17.12.2003
(73) Proprietor: Interuniversitair Microelektronica Centrum (IMEC), 3001 Leuven (BE)
(72) Inventor: Cartier, Eduard, 3000 Leuven (BE); Chen, Jerry, 3000 Leuven (BE); Zhao, Chao, 3010 Kessel-Lo (BE)
(74) Representative: Van Malderen, Joëlle

(56) References cited:
- WO-A1-82/03876
- US-A- 3 634 113
- US-A- 4 626 517
- US-A- 6 060 755
- BYOUNG HUN LEE ET AL: "Thermal stability and electrical characteristics of ultrathin hafnium oxide gate dielectric reoxidized with rapid thermal annealing" APPLIED PHYSICS LETTERS, 3 APRIL 2000, AIP, USA, vol. 76, no. 14, pages 1926-1928, XP002252961 ISSN: 0003-6951
- STEFANIC G ET AL: "The influence of thermal treatment on phase development in ZrO2-Fe2O3 and HfO2-Fe2O3 systems" JOURNAL OF ALLOYS AND COMPOUNDS, ELSEVIER SEQUOIA, LAUSANNE, CH, vol. 327, no. 1-2, 30 August 2001 (2001-08-30), pages 151-160, XP004300945 ISSN: 0925-8388
- KADLEC F ET AL: "High-temperature infrared reflectivity of yttria-stabilized hafnia single crystals" MATERIALS SCIENCE AND ENGINEERING B, ELSEVIER SEQUOIA, LAUSANNE, CH, vol. 72, no. 1, March 2000 (2000-03), pages 56-58, XP004202720 ISSN: 0921-5107
- KUKLI K ET AL: "Comparison of hafnium oxide films grown by atomic layer deposition from iodide and chloride precursors" PREPARATION AND CHARACTERIZATION, ELSEVIER SEQUOIA, NL, vol. 416, no. 1-2, 2 September 2002 (2002-09-02), pages 72-79, XP004389735 ISSN: 0040-6090
- GUSEV E P ET AL: "Ultrathin high-K metal oxides on silicon: processing, characterization and integration issues" MICROELECTRONIC ENGINEERING, ELSEVIER PUBLISHERS BV., AMSTERDAM, NL, vol. 59, no. 1-4, November 2001 (2001-11), pages 341-349, XP004310661 ISSN: 0167-9317
- VLADISLAV V. ET AL: 'Research on the electrochemistry of oxygen ion conductors in the former Soviet Union' JOURNAL OF SOLID STATE ELECTROCHEMISTRY vol. 4, 2000, pages 243 - 266

## Description

### Field of the invention

The present invention is related to transistors or memory capacitors comprising a dielectric layer of compositions comprising HfO₂ and a second compound according to claim 1. The composition is characterized in that at least a part of said composition is in the cubic crystallographic phase. Advantageously, the cubic crystallographic phase is stable at temperatures below 2800 degrees C, preferably below 1200 degrees C. Advantageously the composition has a dielectric value that is higher than the dielectric value of pure HfO₂. Furthermore the present invention is related to a method of production.

### Background

Dielectric materials with high dielectric constants (k-values) are currently explored as possible replacements for SiO₂ which has a dielectric constant of 3.9 and was the dielectric material of choice because of its outstanding physical and electrical properties and because it can be grown thermally directly on silicon in an oxidizing ambient. Alternative metal oxide based dielectric materials, which are under consideration such as SiO₂ replacements, contain elements different from primarily oxygen, nitrogen, and Silicon, such as Y, La, Zr, Hf and many others. Therefore, they have to be deposited and the final properties of the dielectric layer or stack of dielectric layers depend on a number of factors such as the material or materials chosen to form the gate stack, the method of deposition, the sequence of deposition if mixed oxides are deposited, the preparation of the Si surface prior to deposition, the thermal treatment applied after deposition and others.

If a high-k dielectric can be deposited and processed on Si such that the dielectric layers exhibit electrical and physical properties comparable or superior to SiO₂, considerable benefits to the semiconductor industry can be expected through its use. For example, it may be used as a gate dielectric to manufacture transistors and capacitors for future CMOS high-speed logic circuits or to manufacture capacitors for memory applications. Such a high-k dielectric would significantly facilitate the scaling of Si based electronic devices in future CMOS and memory technologies. One of the major advantages would result from a reduction in the gate leakage because the higher k values would allow the use of physically thicker layers without loss of gate capacitance.

It would be advantageous if a dielectric material with a higher k value could be developed, since this allows higher physical thickness to be used.

US2001/0041250 discloses a film comprising a gate dielectric for an IC thin film transistor. The film comprises dielectric materials mixed in a graded fashion to obtain desirable interface properties and desirable bulk properties from another material. For example, Al₂O₃ has a high dielectric constant and desirable interface properties and ZrO₂ has a higher dielectric constant, which is advantageous as bulk material (because of the higher dielectric constant). The films are deposited by atomic layer deposition process.

US6060755 discloses a high-k dielectric film comprising a metal oxide of either Zr or Hf, doped with trivalent elements such as Al. The film remains amorphous at relative high annealing temperatures. The films are deposited by sputtering, CVD or evaporation. The invention described in US6060755 avoids the formation of a crystalline structure.

**[0006a]** Stefanic et al. ("The influence of thermal treatment on phase development in ZrO2-Fe2O3 and HfO2-Fe2O3 systems", Journal of Alloys and compounds, Elsevier Sequoia, Lausanne, CH, vol.327, n°.1-2, 30 August 2001, pages 151-160), mention that cubic polymorphs of ZrO₂ and HfO₂ can be stabilized at room temperature by the incorporation of some metal cations.

**[0006b]** Kadlec et al. ("High temperature infrared reflectivity of yttria-stabilized hafnia single crystals", Materials science and engineering B, Elsevier Sequoia, Lausanne, CH, vol. 72, n°.1, March 2000, pages 56-58) describe the doping of hafnia by yttrium, which stabilizes the cubic phase.

### Aims of the invention

It is an aim of the present invention to disclose a transistor or a memory capacitor comprising a dielectric layer of a composition comprising HfO₂ and a second compound selected from the group consisting of Al, Si, Y, Ce, Mg, Ca, oxides thereof, oxynitrides thereof, transition metal oxides and transition metal oxynitrides, wherein at least a part of said composition is in the cubic crystallographic phase.

### Description of the figures

Figure 1 represents a schematic representation of the cubic (a) and monoclinic (b) crystallographic structure of HfO₂. Figure 1c represents a composition comprising HfO₂ and the second compound.

Figure 2 represents X-ray diffraction spectra for pure HfO₂ (2a) and a mixed oxide (HO:AO (9:1)) (2b) films as deposited and after annealing.

Figure 3 represents of X-ray diffraction spectra for a mixed oxide (HO:AO (4:1)) film (3a) and a mixed oxide (HO:AO (2:1)) film (3b) as deposited and after annealing.

Figure 4 represents a Fourier transform infrared (FTIR) spectra of a HfO₂ layer and of (HO:AO) mixed oxides of various composition annealed at 900 degrees C for 1 min in a N₂ atmosphere.

Figure 5 represents the capacitance equivalent thickness (CET) values as measured by the Quantox™ Q-V method plotted versus the ellipsometric layer thickness for pure HfO₂ layers and for a layer comprising a mixed oxide (HO:AO)(9:1).

Figure 6 represents the capacitance equivalent thickness (CET) values as measured by the Quantox™ Q-V method plotted versus the ellipsometric layer thickness for layers comprising mixed oxides (HO:AO) (18:2) and (HO:AO) (27:3) before and after annealing.

### Summary of the invention

In a first aspect of this invention a transistor or a memory capacitor according to claim 1 is disclosed. In a preferred embodiment, the cubic crystallographic phase is stable at temperatures below 2800 degrees C, preferably below 1200 degrees C.

In an embodiment of the first aspect of the invention, a composition as recited in the first aspect of the invention is disclosed, wherein the dielectric constant of said composition is higher than the dielectric constant of pure HfO₂.

In another embodiment, the dielectric constant of said composition is higher than 20. In a preferred embodiment, the dielectric constant is higher than 28.

In a particular embodiment, said second compound is Al₂O₃.

In an embodiment of the first aspect of the invention, a composition as recited in the first aspect of the invention is disclosed wherein the amount of said second compound is between 1 [mol]% and 90 [mol]%. In a particular embodiment, the amount of said second compound is between 1 [mol]% and 50 [mol]%. In a preferred embodiment, the amount of the second compound is below 4 [mol]%.

In a further aspect of this invention, a transistor or a memory capacitor is disclosed. Said device comprises :
- a first electrode
- a substrate having a top surface underlying said gate electrode
- a dielectric layer interposed between said first electrode and said top surface, said dielectric layer comprising a composition comprising HfO₂ and a second compound wherein at least a part of said composition is in the cubic crystallographic phase.

In an embodiment of this invention, said substrate comprises a channel region, said channel region underlying said dielectric layer. In a particular embodiment of this invention, said substrate further comprises an interfacial layer, said interfacial layer being interposed between the channel region and the dielectric layer. Said interfacial layer can be SiO₂ or SiOH.

In another embodiment, said substrate further comprises a second electrode, said electrode underlying said dielectric layer. Said device can be a memory capacitor.

In another embodiment, the dielectric constant of said composition is higher than the dielectric constant of pure HfO₂.

In another embodiment, said composition can have the characteristics of the composition disclosed in the first aspect of this invention.

In another embodiment, said dielectric film has a thickness between 0.5 nm (5 Å) and 10 nm (100 Å). In a further embodiment, said dielectric layer has an equivalent oxide thickness between 0.05 nm (0.5 Å) and 1.5 nm (15 Å).

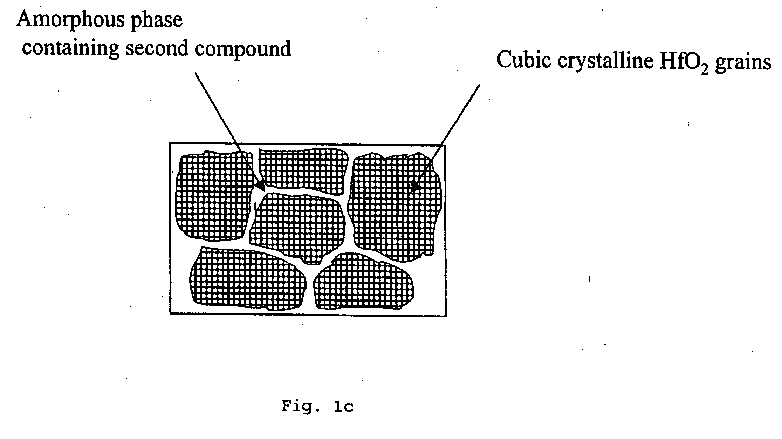

Mixing means that a homogeneous mixture of two compounds is formed (cubic phase HfO₂ and a second compound, see figure 1C) or that a novel compound is formed. The novel compound comprises the individual elements of each of the two compounds chemically bonded. Thus, the novel composition comprises a mixture of HfO₂ and the second compound, either in phase-separated form or in a novel chemical compound, characterized in that at least a part of the novel composition is in the cubic crystallographic phase.

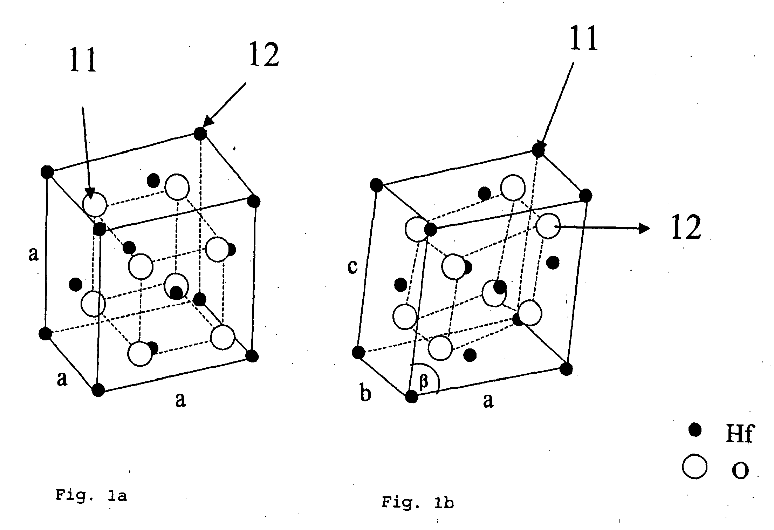

Hafnium oxide is presently investigated as an alternate dielectric material in the semiconductor industry. From room temperature up to 1898 °C, the thermodynamically stable form of crystalline HfO₂ adopts a distorted fluorite (CaF₂) structure, i.e., monoclinic HfO₂, which possesses a dielectric constant (k-value) between about 18 and about 20 as reported in the literature. A schematic representation of the monoclinic HfO₂ is given in Figure 1b (11 represents the oxygen atom while 12 represents the Hf atom). Pure HfO₂ will crystallize into this thermodynamically stable form.

A new crystallographic phase of HfO₂ can be obtained by mixing HfO₂ and a second compound such that a novel composition is formed. The novel composition can be obtained by mixing on an atomic scale. In the prior art, the tetragonal crystallographic phase of HfO₂ is stable between 1800 and 2700 °C, and the monoclinic crystallographic phase of HfO₂ is stable below 1800 °C. The novel composition is stable at temperatures below the melting point of Si. The novel composition is stable below temperatures of 900 degrees C, 1000 degrees C, 1050 degrees C, 1100 degrees C or 1200 degrees C. In the preferred embodiment, the composition is stable at temperatures below 1200 degrees C.

The second compound is selected from the group consisting of Al, Si, Y, Ce, Mg, Ca, oxides thereof, oxonitrides thereof, transition metals oxides and oxynitrides. Transition metals can be Ti, Ta, La and the like. In a particular embodiment, said second compound is a metal oxide. Said metal can be a trivalent metal such as aluminium (Al), lanthanium (La) or Scandium (Sc).

In a particular embodiment, said second compound is Al₂O₃, SiO₂, Y₂O₃, CeO₂, MgO, CaO, TaO₂, La₂O₃ or TiO₂. In a preferred embodiment, the second compound is Al₂O₃.

The dielectric constant of the composition is higher than the dielectric constant of pure (monoclinic) HfO₂. The dielectric constant of the composition is higher than 20, higher than 22, higher than 25. Preferably, the dielectric constant is higher than 28.

The amount of the second compound can be at the highest 90 [mol]%, 80 [mol]%, 70 [mol]%, 60 [mol]%, 50 [mol]%, 40 [mol]%, 30 [mol]%. The amount of the second compound can be between 1 to 50 [mol]%, between 5 and 40 [mol]% and preferably between 9 [mol]% and 24 [mol]%.

The amount of the second compound should be chosen such that the composition is stable in the cubic crystallographic phase and that the dielectric value is higher than the dielectric value of pure HfO₂.

In a particular embodiment, a composition with a lower amount of metal oxide is disclosed. Lower amount should be understood as below 30 [mol]%. This is of particular importance for the optimization of the electrical properties in semiconductor applications and in particular transistor applications. The control of the threshold voltage comprising the dielectric in the gate stack may be facilitated by the use of composition with lower amounts of metal oxide.

The following example describes a composition comprising HfO₂ and Al₂O₃. It is understood however that this concept can be applied to other compositions as recited in this invention.

In a preferred embodiment, the composition which is shown to be stabilized at least up to 1050 °C by mixing Al₂O₃ and HfO₂, and is identified as a cubic crystallographic phase. The cubic crystallographic phase is observed to form in the whole concentration range covering compositions containing from 1 to 30 [mol]% Al₂O₃, preferably 9 to 24 [mol]% Al₂O₃. This range is only mentioned as an example, the phase will also form outside the composition range investigated here. Especially, the admixing of smaller amount of Al₂O₃ is of particular interest, because lower Al₂O₃ content will allow the optimization of the electrical properties of the mixed oxide specifically for application in the semiconductor industry. More specifically, the control of the threshold voltage comprising said dielectric in the gate stack might be facilitated by the use of more dilute oxide mixtures. (The threshold voltage is the voltage at which a transistor can be turned on and/or off.) This is expected because the negative fixed charge due to the Al₂O₃ in the film would be reduced.

First, the dielectric constant of the cubic HfO₂ phase was measured to be at least 29.8, a value significantly higher than the measured dielectric constant of 18 to 20 in the thermodynamically stable orthorhombic or monoclinic phase of HfO₂. This fact allows the use of physically thicker layers with the cubic HfO₂ as compared to the thermodynamically stable phase without any loss of gate capacitance, providing reduced gate leakage currents and widening the process window for film deposition since thicker layers can now be used.

Second, the phase is found to be stable at least up to 900 °C, or at least up to 1050 °C, thus covering a wide portion of the temperature range typically used during semiconductor processing.

The composition can be used for alternate device fabrication processes such as a gate last process flow or replacement gate flow for transistor fabrication. Furthermore, the novel composition can be used for memory storage capacitor and integrated passives applications in memory and mixed-signal devices.

A transistor or memory capacitor device is disclosed. The device comprises a gate electrode, a substrate having a top surface underlying said gate electrode and a dielectric layer interposed between the gate electrode and the top surface. The dielectric layer comprising a composition comprising HfO₂ and a second compound wherein said composition is in the cubic crystallographic phase. The composition can have the characteristic as described in this application.

For transistor applications, the substrate does further comprise a channel region underlying said dielectric layer. The device can further comprise a barrier layer, said barrier layer being interposed between said substrate and said dielectric layer.

For memory applications, the substrate does further comprise an electrode underlying said dielectric layer.

The thickness of the dielectric layer can be between 0.5 nm (5 Å) and 100 nm (1000 Å) between 0.5 nm (5 Å) and 50 nm (500 Å) between 0.5 nm (5 Å) and 10 nm (100 Å). Preferably, the film has a thickness between 0.5 nm (5 Å) and 10 nm (100 Å).

The dielectric layer can have an equivalent oxide thickness (EOT) between 0.05 nm (0.5 Å) and 75 nm (150 Å), between 0.05 nm (0.5 Å) and 7.5 nm (75 Å), between 0.05 nm (0.5 Å) and 1.5 nm (15 Å). Preferably, the EOT of the dielectric layer is between 0.05 nm (0,5 Å) and 1.5 nm (15 Å).

In a further aspect of this invention, a method for forming a dielectric layer on a substrate is disclosed, said method comprising the steps of :
- placing the substrate in a reaction chamber,
- depositing a layer of dielectric material, said dielectric material comprising HfO₂ and a metal oxide, and
- subjecting said deposited dielectric layer to a temperature which is higher than the crystallization temperature of said dielectric material such that at least a part of said composition is in the cubic crystallographic phase.

The annealing temperature is preferably higher than 400 degrees C.

The annealing temperature can be in the range from 400 °C to 1050 °C. The annealing step can be performed in an atmosphere in an ambient comprising at least one compound selected from the group consisting of N₂, He, Ar, O₂, N₂O or NO and mixtures thereof. The pressure can be, but is not limited hereto, 53.33 mbars (40 Torr). Preferably, the annealing temperature is higher than the crystallization temperature of the dielectric material.

The step of subjecting the deposited layer to a temperature can also be performed simultaneously with one of the commonly used processing steps such as the Si gate electrode deposition or an activation anneal. This may facilitate the process since the post deposition anneal is omitted and the structural transformation of the layer to the desired crystalline cubic phase is accomplished.

The step of depositing is done by atomic layer deposition, atomic layer chemical vapor deposition, chemical vapor deposition, metal organo chemical vapor deposition, sputtering or sol-gel deposition.

The substrate can be pretreated such that the surface layer is susceptible for the deposition of the dielectric layer. For example, the substrate can be OH terminated (Si-OH surface) such that the deposition of the dielectric material can be performed by atomic layer deposition.

When the substrate is silicon, the substrate can be covered with a thin interfacial SiO₂ layer (providing a fully or partially OH terminated surface) with a thickness of less than 5 nm, preferably less than 1.5 nm. In an embodiment, two types of interfacial oxides can be used. One is a chemical oxide obtained by an O₃-based clean (IMEC clean). The other is a thermally grown oxide using a rapid thermal oxidation (RTO) process at 650 °C. It is understood that chemical oxides and thermal oxides can be obtained by other methods and/or processing conditions and that interfacial layers produced by such variations can provide similar advantages for the deposition of high-k layers as said preferred methods. While OH terminated surfaces are preferred in this study, it is understood that said composition can also be deposited on any number of other surfaces such as H-terminated Si, metals and others.

### Examples

### Example for HfO₂ - Al₂O₃

For the purpose of this invention, high-k dielectric means a dielectric material having a dielectric value higher than the dielectric value of SiO₂. The term mixed oxide refers to the composition comprising Hafnium oxide (HfO₂) and a metal oxide, in particular Al₂O₃.

### Film Deposition

To obtain homogeneous mixing of the two oxides - Al₂O₃ and HfO₂ - with accurate control, the preferred method is atomic layer deposition (ALD). This method allows the deposition of one ore several oxides with good control of the amount of deposited material as deposition takes advantage of surface saturated reactions and thus can be controlled on a sub monolayer scale by alternating the chemicals used in the deposition process in a pulsed reactor. Using one cycle each of trimethyl aluminum (TMA or Al(CH₃)₃) and H₂O in sequence will yield a sub-monolayer of deposited Al₂O₃, while the use of one cycle each of hafnium tetrachloride (HfCl₄) and H₂O will result in the deposition of a sub-monolayer of HfO₂. Thicker layers of each oxide can be deposited by repeating the deposition cycle. By alternating the gases during the deposition process in the proper manner, mixtures of HfO₂ and Al₂O₃ can be produced with widely varying composition. In the following, the deposition methods are described by the following nomenclature:

x cy (HO:AO (y:z)),

or

x * (y cy HO : z cy AO),

where 'cy' stands for 'cycle', 'HO' stands for 'hafnium oxide' and 'AO' stands for 'aluminum oxide'. The parameter 'y' is the number of HO deposition cycles applied in sequence each comprising a cycle of HfCl₄ and H₂O, 'z' is the number of AO deposition cycles applied in sequence each comprising a cycle of TMA and H₂O and following the y cycles of HO deposition. This whole sequence (HO:AO (y:z)) is then repeated 'x' number of times until the desired thickness is reached. If the deposition is started with an AO cycle, the nomenclature (AO:HO (y:z)) is used instead.

It is understood that said mixed oxides can also be formed by the use of suitable chemical precursors different from those used in the preferred implementation in this study. It is also understood that said mixed oxides can be fabricated by any number of other known methods such as chemical vapor deposition (CVD), plasma enhanced chemical vapor deposition (PECVD), physical vapor deposition (PVD) of metals followed by oxidation or PVD in an oxidizing ambient and variants thereof.

To obtain a homogeneous deposition by ALD, an OH terminated surface is used instead of a H-terminated Si surface, especially for thin films with a thickness of less than 5 nm. All depositions in this study were performed on Si substrates covered with a thin interfacial SiO₂ layer (providing a fully or partially OH terminated surface) with a thickness of less than 1.5 nm. Two types of interfacial oxides have been used. One is a chemical oxide obtained by an O₃-based clean (IMEC clean). The other is a thermally grown oxide using a rapid thermal oxidation (RTO) process at 650 °C. It is understood that chemical oxides and thermal oxides can be obtained by other methods and/or processing conditions and that interfacial layers produced by such variations can provide similar advantages for the deposition of high-k layers as said preferred methods. While OH terminated surfaces are preferred in this study, it is understood that said mixtures of HfO₂ and Al₂O₃ could also be deposited on any number of other surfaces such as H-terminated Si, metals and others.

Table 1 summerizes some of the thin layers deposited by the method of this invention using atomic layer deposition (ALD). For all these layers, a chemical oxide was used as a starting surface for deposition.

Sample #1 to #3 are pure HO depositions yielding the chemical composition HfO₂. After crystallization, only the thermodynamically stable monoclinic crystallographic phase is observed. Samples #4 to #8 list examples of mixed oxides obtained by the said method of the present invention mixing, resulting in mixtures with the listed chemical composition. In all these mixtures, the primary crystallographic phase is found to be of cubic structure. The compositions of the ALCVD deposited HfO₂ and HfO₂-Al₂O₃ alloy layers were measured by x-ray fluorecence (XRF). The structure of the as-deposited layers and of the layers after post-deposition anneals have been tested with grazing incidence X-ray diffraction. To study the crystallization behavior, annealing was performed in N₂ at different temperatures for 1 min.

**Table 1: Compositional and structural analysis of the dielectric layer comprising HfO₂ and Al₂O₃.**

| Sample # | Deposition cycle ratio HO:AO | Deposition cycle | Composition - | Crystalline morphology |
|---|---|---|---|---|
| 1 | 1:0 | 80 cy HO | HfO₂ | monoclinic |
| 2 | 1:0 | 160 cy HO | HfO₂ | monoclinic |
| 3 | 1:0 | 320 cy HO | HfO₂ | monoclinic |
| 4 | 9:1 | 8 * (9cy HO : 1 cy AO) | Hf₅AlOₓ | cubic |
| 5 | 9:1 | 16 * (9cy HO: 1 cy AO) | Hf₅AlOₓ | cubic |
| 6 | 9:1 | 32 * (9cy HO : 1 cy AO) | Hf₅AlOₓ | cubic |
| 7 | 18:2 | 4*(18cy HO:2 cy AO) | Hf₅AlOₓ | cubic |
| 8 | 18:2 | 8*(18cy HO:2 cy AO) | Hf₅AlOₓ | cubic |
| 9 | 27:3 | 3*(27cy HO:3 cy AO) | Hf₅AlOₓ | cubic |
| 9 | 27:3 | 6*(27cy HO:3 cy AO) | Hf₅AlOₓ | cubic |
| 10 | 4:1 | 16 * (4cy HO : 1 cy AO) | Hf_{2.6}AlOₓ | cubic |
| 11 | 2:1 | 25 * (2cy HO : 1 cy AO) | Hf_{1.6}AlOₓ | cubic |

### Structural analysis using X-ray diffraction

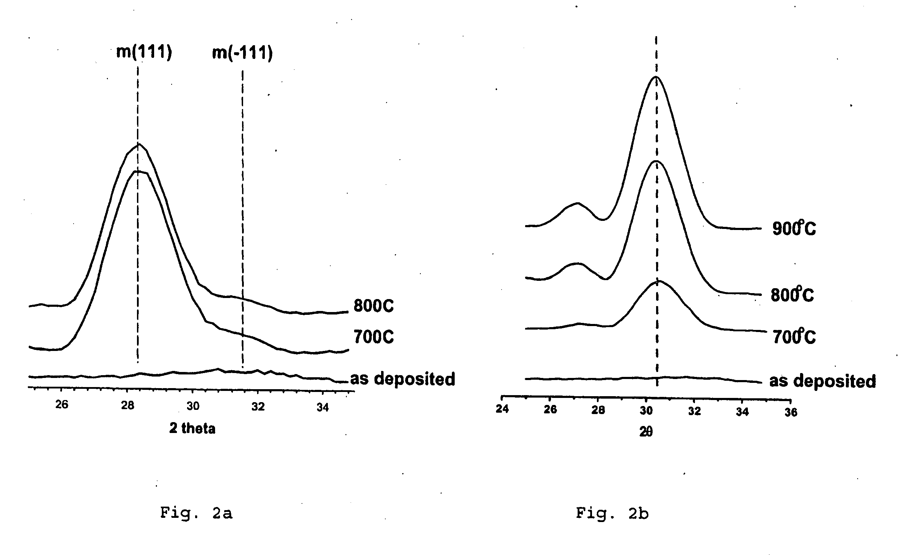

- To analyze the structure of the thin layers deposited in this study, grazing incidence X-ray diffraction (XRD) was used. The mophologies of all *as-deposited* layers were found to exhibit an XRD pattern typically observed for amorpous layers. Examples for various compositions are shown in Figures 2-3. Figure 2 summarizes and compares the cristallization behavior of pure HfO₂ (figure 2a) and of a mixed (HO:AO) (9:1) layer (figure 2b). XRD spectra have been recorded for as deposited films (no anneal) and for films undergoing a post deposition anneal (PDA) at 700 °C, 800 °C and 900 °C for 1 minute.

The approximate layer thickness as measured by spectroscopic ellipsometry is 4.9-5.3 nm for pure HfO₂ and 5.0-5.5 nm for the (9:1) mixed Hf:Al oxide. In both cases, the as deposited films exhibit an X-ray pattern typical for an amorphous layer. Both layers show signs of crystallization after anneals at temperatures higher than 700 °C (700 °C, 800 °C and 900 °C were tested) . Pure HfO₂ is observed to crystallize into the monoclinic phase, with the dominant reflection peaks as marked in figure 2a. The film containing aluminium crystallizes into the cubic phase with the dominant reflection as marked in figure 2b. The cubic phase was observed at all three temperatures measured, 700 °C, 800 °C, and 900 °C.

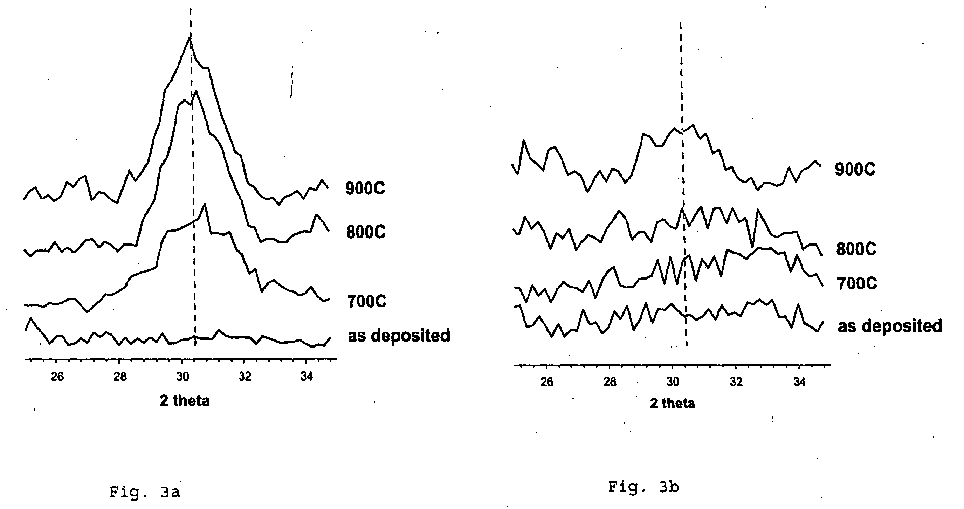

Figure 3 represents the X-ray diffraction spectra of mixed Hf:Al oxide layers deposited with a ratio of (HO:AO (4:1)) (figure 3a) and (HO:AO (2:1)) (figure 3b). XRD spectra have been recorded for as deposited films (no anneal) and for films undergoing a post deposition anneal (PDA) at 700 °C, 800 °C and 900 °C for 1 minute.

The approximate layer thickness as measured by spectroscopic ellipsometry is 5.0-5.6 nm for the (4:1) composition and 5.2-5.6 nm for the (2:1) composition. Before annealing, the layers are found to exhibit X-ray spectra typical for amorphous layers. After annealing, the cubic HfO₂ phase can be observed in both layers. The crystallization temperature is observed to be higher for larger aluminium content in the layer.

To characterize the new cubic phase more rigorously, XRD spectra were measured scan over a wider angular range and in thicker layers. Two measured XRD spectra are compared with a simulated XRD spectrum (botfor the cubic HfO₂ phase schematically shown in Figure 1. The diffraction peak positions and intensities measured in the two thicker Hf₅AlOₓ layers agree well with the simulation for a cubic HfO₂ phase with a lattice parameter a = 0.504 nm.

### Structural studies using Fourier transform infrared spectroscopy

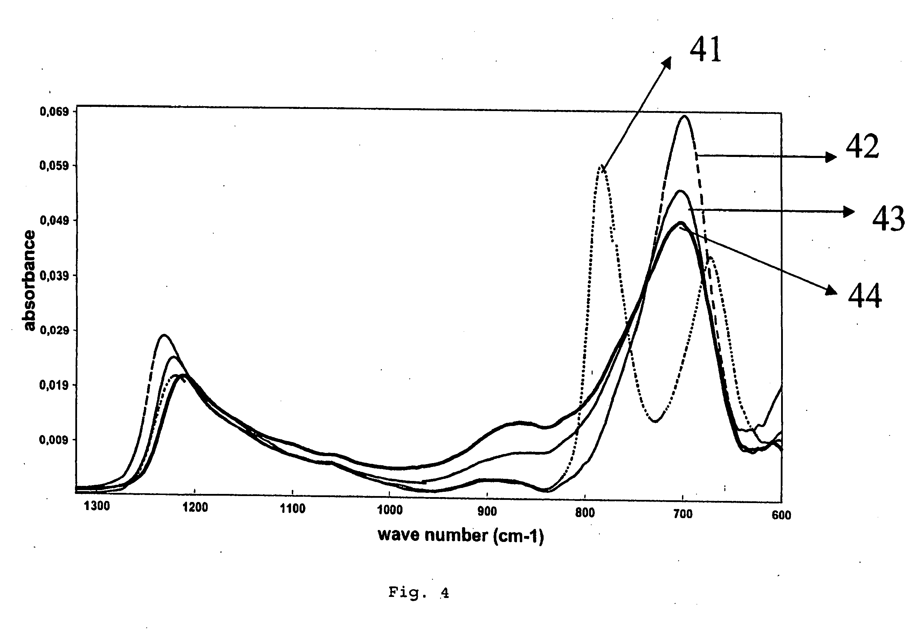

Figure 4 represents Fourier transform infra-red (FTIR) spectra for (HO:AO) mixed oxide layers with deposition ratios of (9:1) (curve 42), (4:1) (curve 43) and (2:1) (curve 44) and a layer of pure HfO₂ (curve 41). FTIR spectra of these films are shown after annealing at 900 °C. Annealing was done in 53.33 mbars (40 Torr) of N₂ for one minute. All spectra consist of two distinct regions. The vibrations in the range from about 1300 to about 1100 wave numbers correspond to vibrations in said SiO₂ layer used as a starting layer for HO and HO:AO deposition. A chemical oxide was used in this case. The vibrations below about 1050 wave numbers correspond to vibrations in the HfO₂ and/or (HO:AO) mixed oxide layers and can be used to study their structure. It can also be seen, that the vibration spectra of the two materials is distinctly different. The spectrum of pure HfO₂ consists of two sharp vibration bands in the metal oxide spectral region at wave numbers of approximately 780 and 670 wave numbers. In contrast, spectrum of all mixed oxides shows only on single vibration band near 700 wave numbers as expected for a crystal structure with high symmetry like the cubic structure. It should also be noted that no significant spectral changes occur in the FTIR region of the interfacial oxide layer, indicating that it is stable during the applied heat treatments.

### Electrical characterization

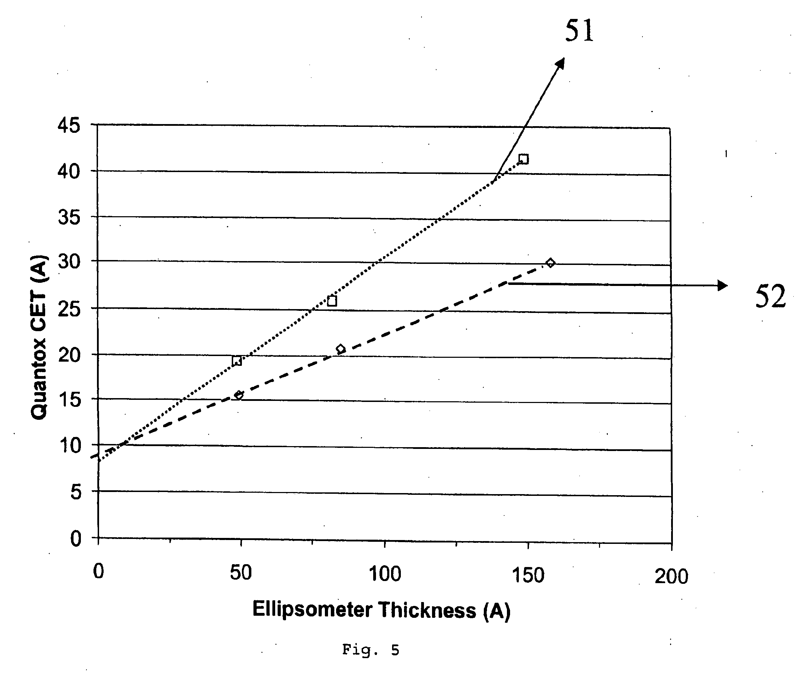

Figure 5 represents the results of the electrical measurements performed on these same layers. The dielectric constant of the layers is measured by the method illustrated in Figure 5. In Figure 5, the capacitance equivalent thickness (CET) values as measured by the Quantox™ Q-V method (other methods can be used to measure the CET values) are plotted versus the ellipsometric layer thickness for pure HfO₂ layers (□ or 51) and HO:AO(9:1) mixed oxide layers (◇ or 52) of varying thickness. Both layers were annealed at 800 °C in 53.33 mbars (40 Torr) of N₂ for 1 min prior to the CET evaluation. The ellipsometric layer thickness is used as an approximate measure for the true physical thickness of the high-k layer. Since the layer consists of two dielectric materials, the interfacial oxide and the high-k film, CET can be expressed as follows,

CET: = EOT := t_{SiO2} + k_{SiO2} / kₕᵢₖ * tₑₗₗ,

where EOT stands for equivalent oxide thickness (an often used synonym for CET), t_{SiO2} is the interfacial oxide layer thickness, k _{SiO2} is the dielectric constant of silicon dioxide with a value of 3.9, kₕᵢₖ is the dielectric constant of the deposited high-k layer and tₑₗₗ is the ellipsometric thickness of the high-k layer. From this equation, it can be seen that the dielectric constant of the high-k layer is inversely proportional to the slope of the data sets in Figure 5 and that the intercept with the CET axes provides a measure for the interfacial oxide thickness.

Applied to the data in Figure 5, a value of 18 is obtained for the dielectric constant of pure HfO₂, while a higher value of 29.8 is extracted for the (9:1) mixed oxide. The interfacial oxide layer thickness is found to be about 0.8-0.9 nm, in good agreement with the nominal thickness resulting from the growth of a chemical oxide using an IMEC clean. It also confirms for the FTIR observation that the interfacial layer is not significantly modified during annealing.

As can be seen from the mixed oxide data in Figure 5, annealing (here at 800 °C) results in a reduction of the CET value as compared to that of the *as deposited* film. For HfO₂ films, no k-value enhancement is observed.

Based on all the findings, the preferred annealing temperatures for the (9:1) mixed oxide are said to be in the range from above the crystallization temperature of the (9:1) mixed oxide to about 800 °C, however, an annealing temperature range from about 400 °C to about 1050 °C may be useful. The ambient atmosphere for post deposition annealing used in this study was about 53.33 mbars (40 Torr) of N₂. It is noted, however, that the new phase can likely also be formed by annealing in other inert ambient gases frequently used for such anneals, such as He, Ar, or mixtures of these with N₂ or oxidizing ambient such as O₂, N₂O or NO. Furthermore, the use of such layers in semiconductor manufacturing may be facilitated if the post deposition anneal is omitted all together and the structural transformation of the layer to the desired crystalline cubic phase is accomplished simultaneously with one of the commonly used processing steps such as the Si gate electrode deposition or an activation anneal.

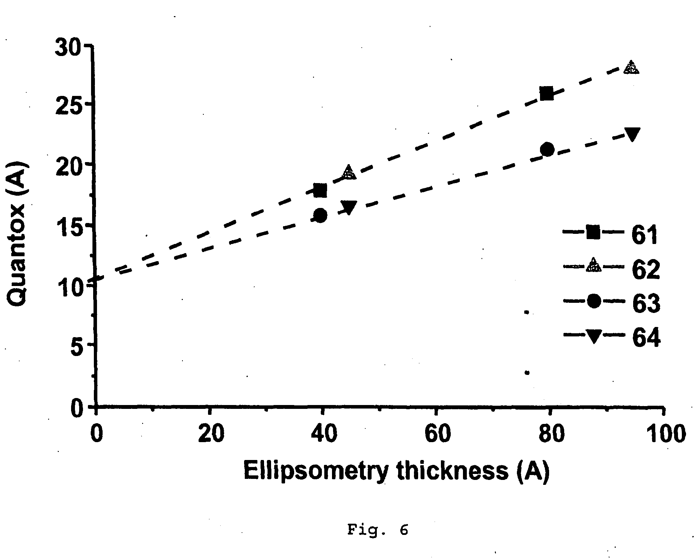

Figure 6 shows similar results obtained with sample of HO:AO = 18:2 and 27:3. 61 represents the results for HO:AO (18:2) before anneal, 62 represents the results for HO:AO (27:3) before anneal. Before annealing, the as-deposited layers, which have amorphous phases, have a k-value of about 20. 63 represents the results for HO:AO (18:2) after anneal, 64 represents the results for HO:AO (27:3) after anneal. After annealing, the as-deposited films have dominantly cubic crystalline HfO₂ phase, have a k-value around 29. This shows further the correspondence between the high k-value and the cubic HfO₂. The k-value of the amorphous phase is a little bit smaller than that of the pure HfO₂ after annealing, as shown in Fig.9. The intercept of the two curves with the y-axes corresponds to the CET value of a 1.0 nm thick SiO₂ layer, revealing that the annealing does not increase the thickness of the interfacial SiO₂ layer.

## Claims

1. A transistor or a memory capacitor comprising a dielectric layer of a composition comprising HfO₂ and a second compound selected from the group consisting of Al, Si, Y, Ce, Mg, Ca, oxides thereof, oxynitrides thereof, transition metal oxides and transition metal oxynitrides, wherein at least a part of said composition is in the cubic crystallographic phase.

2. A transistor or a memory capacitor according to claim 1, wherein said dielectric layer is interposed between an electrode and a substrate.

3. A transistor according to claim 2, wherein said substrate comprises a channel region underlying said dielectric layer.

4. A memory capacitor according to claim 2, wherein said substrate comprises a second electrode underlying said dielectric layer.

5. A transistor or a memory capacitor according to any of claims 1 to 4, wherein the dielectric constant of said dielectric layer is higher than the dielectric constant of pure HfO₂.

6. A transistor or a memory capacitor according to any of claims 1 to 5, wherein said dielectric layer is stable at temperatures below 1200° C.

7. A transistor or a memory capacitor according to any of claims 1 to 6, wherein said second compound is Al₂O₃.

8. A transistor or a memory capacitor according to any of claims 1 to 7, wherein said second compound is in an amount comprised between 1 [mol]% and 50 [mol]%.

9. A transistor or a memory capacitor according to any of claims 1 to 8, wherein said dielectric layer has a thickness between 0,5 nm (5 Å) and 10 nm (100 Å).

10. A transistor or a memory capacitor according to any of claims 1 to 9, wherein said dielectric layer has an equivalent oxide thickness comprised between 0,05 nm (0.5 Å) and 1,5 nm (15 Å).

11. A transistor or a memory capacitor according to any of claims 1 to 10 further comprising an interfacial layer between said dielectric layer and said substrate.

12. A method for manufacturing a transistor or a memory capacitor according to any of claims 1 to 11, comprising the steps of :
- placing a substrate in a reaction chamber,
- depositing on said substrate a dielectric layer of a composition comprising HfO₂ and a second compound selected from the group consisting of Al, Si, Y, Ce, Mg, Ca, oxides thereof, oxynitrides thereof, transition metal oxides and transition metal oxynitrides, and
- subjecting said deposited dielectric layer to a temperature which is higher than the crystallization temperature of said layer such that at least a part of said layer is transformed in the cubic crystallographic phase.

13. A method according to claim 12, wherein said step of depositing is done by atomic layer deposition.

14. A method according to claim 12 or 13, wherein said temperature is higher than 400 degrees C.

15. A method according to any of claims 12 to 14, wherein said temperature is between 400 degrees C and 1050 degrees C.

16. A method according to any of claims 12 to 15, wherein said substrate comprises an interfacial layer.

## Patentansprüche

1. Transistor oder Speicherkondensator, umfassend eine dielektrische Schicht aus einer Zusammensetzung, welche HfO₂ und eine zweite Verbindung umfasst, die aus der aus Al, Si, Y, Ce, Mg, Ca, Oxiden davon, Oxynitriden davon, Übergangsmetalloxiden und Übergangsmetall-Oxynitriden bestehenden Gruppe ausgewählt ist, wobei zumindest ein Teil der Zusammensetzung in der kubischen kristallographischen Phase ist.

2. Transistor oder Speicherkondensator nach Anspruch 1, wobei die dielektrische Schicht zwischen einer Elektrode und einem Substrat angeordnet ist.

3. Transistor nach Anspruch 2, wobei das Substrat ein Kanalgebiet umfasst, das unter der dielektrischen Schicht liegt.

4. Speicherkondensator nach Anspruch 2, wobei das Substrat eine zweite Elektrode umfasst, die unter der dielektrischen Schicht liegt.

5. Transistor oder Speicherkondensator nach einem der Ansprüche 1 bis 4, wobei die dielektrische Konstante der dielektrischen Schicht höher ist als die dielektrische Konstante von reinem HfO₂.

6. Transistor oder Speicherkondensator nach einem der Ansprüche 1 bis 5, wobei die dielektrische Schicht bei Temperaturen unter 1200 °C stabil ist.

7. Transistor oder Speicherkondensator nach einem der Ansprüche 1 bis 6, wobei die zweite Verbindung Al₂O₃ ist.

8. Transistor oder Speicherkondensator nach einem der Ansprüche 1 bis 7, wobei die zweite Verbindung in einer Menge von zwischen 1 Mol% und 50 Mol% vorhanden ist.

9. Transistor oder Speicherkondensator nach einem der Ansprüche 1 bis 8, wobei die dielektrische Schicht eine Dicke zwischen 0,5 nm (0,5 Å) und 10 nm (100 Å) aufweist.

10. Transistor oder Speicherkondensator nach einem der Ansprüche 1 bis 9, wobei die dielektrische Schicht eine äquivalente Oxiddicke zwischen 0,05 nm (0,5 Å) und 1,5 nm (15 Å) aufweist.

11. Transistor oder Speicherkondensator nach einem der Ansprüche 1 bis 10, ferner umfassend eine Grenzflächenschicht zwischen der dielektrischen Schicht und dem Substrat.

12. Verfahren zur Herstellung eines Transistors oder eines Speicherkondensators nach einem der Ansprüche 1 bis 11, das die folgenden Schritte umfasst:
- das Anordnen eines Substrats in einer Reaktionskammer,
- das Abscheiden einer dielektrischen Schicht aus einer Zusammensetzung, welche HfO₂ und eine zweite Verbindung umfasst, die aus der aus Al, Si, Y, Ce, Mg, Ca, Oxiden davon, Oxynitriden davon, Übergangsmetalloxiden und Übergangsmetall-Oxynitriden bestehenden Gruppe ausgewählt ist, auf dem Substrat,
- das Aussetzen der abgeschiedenen dielektrischen Schicht einer Temperatur, die höher ist als die Kristallisationstemperatur der Schicht, sodass zumindest ein Teil der Schicht in die kubische kristallographische Phase umgewandelt wird.

13. Verfahren nach Anspruch 12, wobei der Schritt des Abscheidens mittels Atomlagenabscheidung durchgeführt wird.

14. Verfahren nach Anspruch 12 oder 13, wobei die Temperatur über 400 °C liegt.

15. Verfahren nach einem der Ansprüche 12 bis 14, wobei die Temperatur zwischen 400 °C und 1050 °C liegt.

16. Verfahren nach einem der Ansprüche 12 bis 15, wobei das Substrat eine Grenzflächenschicht umfasst.

## Revendications

1. Transistor ou condensateur de mémoire comprenant une couche diélectrique d'une composition comprenant HfO₂ et un second composé choisi dans le groupe constitué par Al, Si, Y, Ce, Mg, Ca, leurs oxydes, leurs oxynitrures, des oxydes de métaux de transition et des oxynitrures de métaux de transition, dans lequel au moins une partie de ladite composition est dans la phase cristallographique cubique.

2. Transistor ou condensateur de mémoire selon la revendication 1, dans lequel la couche diélectrique est interposée entre une électrode et un substrat.

3. Transistor selon la revendication 2, dans lequel ledit substrat comprend une région de canal située sous ladite couche diélectrique.

4. Condensateur de mémoire selon la revendication 2, dans lequel ledit substrat comprend une seconde électrode située sous ladite couche diélectrique.

5. Transistor ou condensateur de mémoire selon l'une quelconque des revendications 1 à 4, dans lequel la constante diélectrique de ladite couche diélectrique est supérieure à la constante diélectrique du HfO₂ pur.

6. Transistor ou condensateur de mémoire selon l'une quelconque des revendications 1 à 5, dans lequel ladite couche diélectrique est stable à des températures inférieures à 1 200 °C.

7. Transistor ou condensateur de mémoire selon l'une quelconque des revendications 1 à 6, dans lequel ledit second composé est Al₂O₃.

8. Transistor ou condensateur de mémoire selon l'une quelconque des revendications 1 à 7, dans lequel ledit second composé se trouve en une quantité comprise entre 1 % en [mol] et 50 % en [mol].

9. Transistor ou condensateur de mémoire selon l'une quelconque des revendications 1 à 8, dans lequel ladite couche diélectrique a une épaisseur comprise entre 0,5 nm (5 Å) et 10 nm (100 Å).

10. Transistor ou condensateur de mémoire selon l'une quelconque des revendications 1 à 9, dans lequel ladite couche diélectrique a une épaisseur équivalente d'oxyde comprise entre 0,05 nm (0,5 Å) et 1,5 nm (15 Å).

11. Transistor ou condensateur de mémoire selon l'une quelconque des revendications 1 à 10, comprenant en outre une couche interfaciale entre ladite couche diélectrique et ledit substrat.

12. Procédé de fabrication d'un transistor ou d'un condensateur de mémoire selon l'une quelconque des revendications 1 à 11, comprenant les étapes consistant à :
- placer un substrat dans une chambre de réaction,
- déposer sur ledit substrat une couche diélectrique d'une composition comprenant HfO₂ et un second composé choisi dans le groupe constitué par Al, Si, Y, Ce, Mg, Ca, leurs oxydes, leurs oxynitrures, des oxydes de métaux de transition et des oxynitrures de métaux de transition, et
- soumettre ladite couche diélectrique déposée à une température supérieure à la température de cristallisation de ladite couche, de sorte qu'au moins une partie de ladite couche est transformée en la phase cristallographique cubique.

13. Procédé selon la revendication 12, dans lequel ladite étape de dépôt est effectuée par dépôt de couche atomique.

14. Procédé selon la revendication 12 ou 13, dans lequel ladite température est supérieure à 400 degrés C.

15. Procédé selon l'une quelconque des revendications 12 à 14, dans lequel ladite température est comprise entre 400 degrés C et 1 050 degrés C.

16. Procédé selon l'une quelconque des revendications 12 à 15, dans lequel ledit substrat comprend une couche interfaciale.
